# NEUE EUROPÄISCHE PATENTSCHRIFT

(11) **EP 0 329 807 B2**
(45) Veröffentlichungstag und Bekanntmachung des Hinweises auf die Entscheidung über den Einspruch: **22.01.2003**
(45) Hinweis auf die Patenterteilung: 31.03.1993
(21) Anmeldenummer: 88102800.5
(22) Anmeldetag: 25.02.1988
(51) Int. Cl.: H05K 13/00, H05K 3/26

(54) **Vorrichtung zur Behandlung von elektrischen Leiterplatten**
Circuit for processing electrical printed-circuit boards
Dispositif de traitement de cartes électriques à circuits imprimés

(43) Veröffentlichungstag der Anmeldung: 30.08.1989
(73) Patentinhaber: Gebr. Schmid GmbH & Co., D-72250 Freudenstadt (DE)
(72) Erfinder: Schmid, Dieter C., Dipl.-Ing., D-7290 Freudenstadt (DE)
(74) Vertreter: Patentanwälte Ruff, Wilhelm, Beier, Dauster & Partner

(56) Entgegenhaltungen:
- EP-A- 0 204 609
- EP-B- 0 078 900
- EP-B- 0 212 253
- WO-A-86/06243
- DE-A- 3 038 841
- DE-C- 2 606 984
- DE-C- 3 001 726
- DE-C- 3 022 146
- DE-C- 3 226 621
- DE-C- 3 236 545
- FR-A- 2 412 357
- US-A- 3 593 677
- US-A- 4 622 917
- Zeugnis des Mr. Gareth Weed von der FSL GB vom 13.12.1993
- Zeugnis des Mr. Graham Chaplin von der Olin Corporation von 02.11.1993
- Zeugnis des Mr. Patrick J. Sinnott von der FSL GB vom 29.10.1993
- Zeugnis des Mr. David Neale vom 28.09.1993
- Zeichnung vom 19.01.1988
- Kopie eines Dokuments mit dem Titel: "Besucherliste"
- Schreiben des Mr. C.H. Garnett von der Printed Circuit Association vom 10.02.1988
- Schreiben des Mr. Terry Hibbs von der RCI Rapid Circuit Imprimé vom 16. Februar 1988
- Schreiben des Mr. Jim Robertson von der OMI International (G.B.) Ltd. vom 28.01.1988
- Schreiben des Mr. D.J. Fish von der Circast Electronics Ltd. vom 22.01.1988
- Schreiben des Mr. John Dutton und Alex Gordon von der Shipley Europe Ltd. vom 22.01.1988
- Schreiben des Mr. Skelton von der Clasical Circuit Ltd. vom 22.01.1988
- Gerold Mueller-Ensslin, Dokumentation Leiterplatten-Seminar 1981; Seiten 2,3; Absaetze "Fluxer","SLC-Zone"
- Hans-Juergen Ehrlich, Metalloberflaeche, 40 (1986) 11, Seiten 459-464, insb. Seite 463, linke Spalte
- Galvanotechnik 74, Nr. 10 (1983), S. 1259-1264
- Mueller, G. Chemische Bohrlochreinigung von Multilayern mit Schwefelsaeure. VDI/VDE "Leiterplatte 86", Fachtagung Karlsruhe, Ber. S. 66-73

## Beschreibung

Die Erfindung betrifft eine Vorrichtung zur Behandlung von elektrischen Leiterplatten in einem oder in mehreren Flüssigkeitsbädern.

Elektrische Leiterplatten werden mit Bohrungen zur Aufnahme der Anschlüsse elektrischer Elemente versehen. Diese Bohrlöcher müssen bei der Bearbeitung gereinigt werden, wobei die immer kleiner werdenden Abmessungen die zuverlässige Reinigung der Bohrlöcher erschweren. Beispielsweise werden in Leiterplatten Bohrungen mit Durchmessern von 0,2 mm benötigt, die während der Bearbeitung unter Umständen wiederholt von Trägermaterialresten, Behandlungsflüssigkeit und anderen Verunreinigungen gesäubert werden müssen.

Die Bohrungen in Leiterplatten dienen außerdem der elektrischen Verbindung von Plattenoberzu Plattenunterseite. Vor der Kontaktierung durch chemisches/galvanisches Kupfer ist ebenfalls eine gründliche Bohrlochreinigung unumgänglich.

Es ist bekannt, die Bohrlochreinigung dadurch vorzunehmen, daß eine Behandlungsflüssigkeit strahlförmig gegen die Oberfläche der Leiterplatte gerichtet wird, die dabei teilweise auch durch die Bohrlöcher hindurchtritt. Diese Reinigung kann mittels Gas- oder Flüssigkeitsstrahl erfolgen.

Obwohl auf diese Weise bei Bohrlöchern größeren Durchmessers eine zufriedenstellende Reinigung erzielt werden kann, ergeben sich bei Bohrlöchern mit kleineren Durchmessern bei dieser Art der Bohrlochreinigung Schwierigkeiten. Insbesondere hat sich als nachteilig herausgestellt, daß aus den Bohrlöchern ausgespülte Verunreinigungen auf die Oberfläche der Leiterplatte und insgesamt in die Behandlungsflüssigkeit gelangen, so daß mit zunehmender Betriebsdauer die Gefahr einer Verunreinigung der Leiterplatte steigt.
Die US 4,622,917 A zeigt eine Vorrichtung, bei der eine Leiterplatte in einer Führungsschiene stehend in einer Behandlungskammer angeordnet ist, durch deren gelochte Wände Strahlen von Behandlungsflüssigkeit auf die Leiterplatte gerichtet werden, die Löcher in der Platte durchströmen sollen. Auf der gegenüberliegenden Seite wird die Behandlungsflüssigkeit durch die gelochte Wand abgesaugt, die in einem Abstand von der Leiterplatte angeordnet ist. Die Platte kann oszillierend bewegt werden. Die JP 62-77495 A zeigt eine ähnliche Vorrichtung, jedoch ohne Führungsschiene und Oszillation.

Aus der FR-A-2 412 357 ist eine Vorrichtung zur Reinigung von Gegenständen, u. a. Leiterplatten, bekanntgeworden, die einer galvanischen oder chemischen Behandlung nachgeschaltete, einander gegenüberliegende Absaugdüsen aufweist, die Reste der Behandlungsflüssigkeit absaugen.

Es ist Aufgabe der Erfindung, eine Vorrichtung zur Behandlung derart zu verbessern, daß einerseits auch bei Bohrungen mit sehr kleinen Durchmessern eine effektive Reinigung der Bohrlöcher erfolgen kann und andererseits eine Ablagerung von Verunreinigung auf den Leiterplattenflächen vermieden wird.

Diese Aufgabe wird durch den Anspruch 1 gelöst.

Es hat sich überraschenderweise herausgestellt, daß bei Behandlung in einem Bad die Verwendung einer Absaugung an mindestens einer Plattenseite einerseits dazu führt, daß die Behandlungsflüssigkeit die Bohrlöcher mit größerer, Strömungsgeschwindigkeit durchsetzt, so daß auf diese Weise eine einwandfreie Reinigung der Bohrlöcherinnenflächen erreicht werden kann, während andererseits durch die Behandlungsflüssigkeit ausgespülte Verunreinigungen unmittelbar durch die Absaugung aufgenommen werden, so daß eine Ablagerung dieser Verunreinigungen auf der Leiterplattenoberfläche oder in der Behandlungsflüssigkeit vermieden wird.

Besonders vorteilhaft ist es, wenn die Absaugung eine in das Flüssigkeitsbad führende Rückführung aufweist. Auf diese Weise kann die gesamte Flüssigkeit gegebenenfalls nach Reinigung in einer Filtervorrichtung dem Behandlungsbad wieder Zugeführt werden, so daß Verluste an Badflüssigkeit weitgehend vermieden werden, wobei gleichzeitig die Badflüssigkeit auf diese Weise laufend gefiltert wird.

Das Flüssigkeitsbad, in dessen Innerem die Absaugung angeordnet ist, kann ein Bad einer beliebigen Behandlungsflüssigkeit sein, beispielsweise ein Reinigungs-, ein Vorbehandlungs-, ein Aktivierungs-, ein Neutralisierungs- oder auch ein Abscheidungsmedium, je nachdem, welche Behandlung an der Leiterplatte jeweils vorgenommen werden soll. Dabei ist unter Umständen die Durchströmung der Bohrlöcher nicht nur zu Reinigungszwecken notwendig, sondern auch um den Kontakt der Behandlungsflüssigkeit mit den Bohrlochwänden zu garantieren, wenn nämlich die Behandlungsflüssigkeit die Bohrlochwände bearbeitet, beispielsweise beim chemischen oder physikalischen Aufrauhen der Bohrlochinnenwand. Eine Behandlungsflüssigkeit kann auch ein flüssiges Lot sein. Die Anordnung kann auch angewendet werden beim Abscheiden von Aktivatoren an den Bohrungswandungen und beim chemischen Abscheiden, z. B. von Kupfer, und beim galvanischen Verstärken chemischer Abscheidungen.

Eine besonders vorteilhafte Reinigungswirkung ergibt sich dann, wenn auf der der Absaugung abgewandten Seite der Leiterplatte eine Ultraschallreinigungsvorrichtung in der Flüssigkeit angeordnet ist, wobei diese vorzugsweise der Absaugung unmittelbar gegenüberliegt.

Da der Absaugung gegenüber eine die Flüssigkeit gegen die Leiterplatte richtende Fördereinrichtung angeordnet ist, wird die Durchströmung der Bohrlöcher unterstützt. Beispielsweise kann eine sogenannte Schwallwelle vorgesehen sein, die Behandlungsflüssigkeit von unten nach oben durch eine Leiterplatte durchdrückt. Die Absaugung befindet sich dann auf der Oberseite in dem Bereich der Flüssigkeit, der über die Oberseite der Leiterplatte hervortritt, so daß in diesem Bereich die Behandlungsflüssigkeit nach dem Durchströmen der Leiterplatte abgesaugt wird und nicht auf die Oberfläche der Leiterplatte gelangt, auf der Verunreinigungen in dieser Behandlungsflüssigkeit abgelagert werden könnten.

Besonders vorteilhaft ist es, wenn beiden Seiten der Leiterplatte je mindestens eine Absaugung zugeordnet ist, wobei die Absaugungen einander unmittelbar gegenüberliegend angeordnet sein können, sie können aber in Transportrichtung der Leiterplatten auch gegeneinander versetzt sein.

Bei der bevorzugten Ausführungsform ist vorgesehen, daß die Absaugung eine Fluidstrahlpumpe umfaßt, beispielsweise eine Wasserstrahlpumpe. Diese hat sich zur Absaugung von Behandlungsflüssigkeit als besonders geeignet erwiesen, obwohl natürlich anstelle einer solchen Fluidstrahlpumpe auch Pumpen anderen Typs Verwendung finden können.

Die Absaugung weist einen sich quer zur Leiterplatte erstreckenden Absaugschlitz auf, an dem die Leiterplatte vorbeibewegt wird, so daß die gesamte Oberfläche der Leiterplatte von dem Absaugschlitz überstrichen wird. Quer bedeutet dabei vorzugsweise senkrecht zur Förderrichtung, es ist jedoch auch möglich, den Absaugschlitz unter einem Winkel relativ zur Förderrichtung anzuordnen, beispielsweise unter einem Winkel von 45°.

Günstig ist es, wenn der Absaugschlitz eine Schlitzbreite zwischen 0,2 und 5 mm hat.

Zur effektiven Absaugung liegt der Abstand der Absaugung von der Leiterplatte zwischen 0,1 und 5 mm.

Die nachfolgende Beschreibung bevorzugter Ausführungsformen dient im Zusammenhang mit der Zeichnung der näheren Erläuterung. Es zeigt:
- Fig. 1: eine schematische Längsschnittansicht einer Behandlungsstation mit einer Absaugung an der Unterseite einer Leiterplatte;
- Fig. 2: eine Ansicht ähnlich Fig. 1 mit einem zusätzlichen Ultraschallschwinger auf der Oberseite der Leiterplatte und
- Fig. 3: eine Längsschnittansicht einer Behandlungsstation und einer daran anschließenden Absaugung zur Herabsetzung der Flüssigkeitsverschleppung.

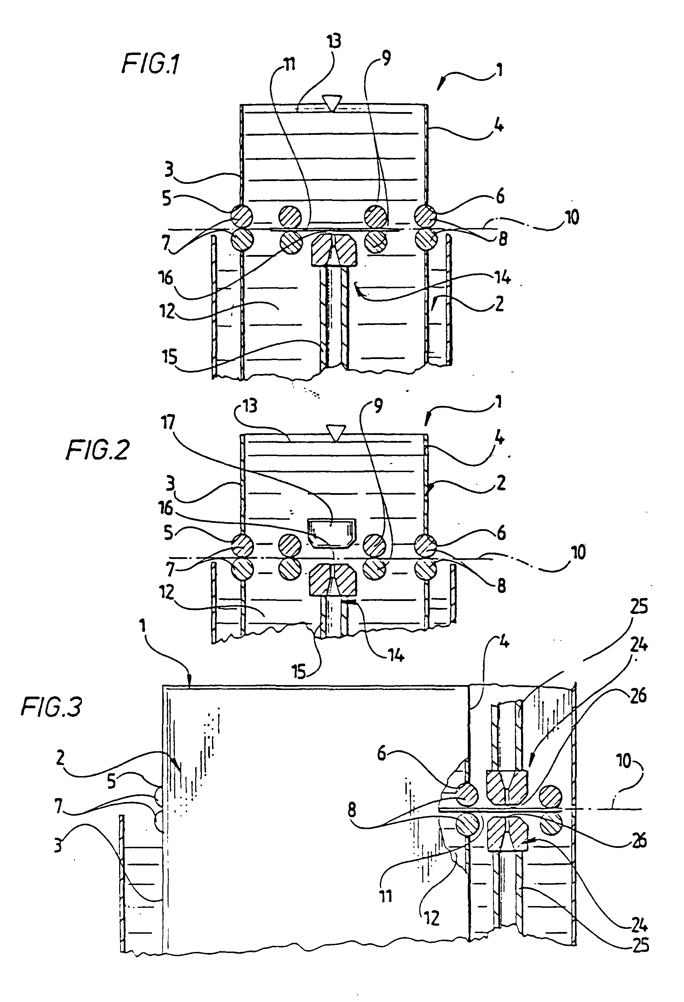

Die in Fig. 1 dargestellte Behandlungsstation 1 umfaßt einen Behälter 2, in dessen Vorderwand 3 und Rückwand 4 jeweils ein horizontaler Schlitz 5 bzw. 6 angeordnet ist, die in derselben Horizontalebene liegen. In jedem der Schlitze 5 und 6 ist jeweils ein Walzenpaar 7 bzw. 8 angeordnet mit zwei einander gegenüberliegenden, längs des Schlitzes verlaufenden Walzen, von denen die obere in aus der Zeichnung nicht ersichtlicher Weise unter der Wirkung des Eigengewichtes oder einer Feder gegen die untere gedrückt ist. In dem Behälter 2 können sich weitere Walzenpaare 9 befinden, die zusammen mit den Walzenpaaren 7 und 8 eine Vorschubebene 10 für Leiterplatten 11 bilden.

Der Behälter 2 ist mit einer Behandlungsflüssigkeit 12 gefüllt, die durch geeignete, in der Zeichnung nicht dargestellte Pumpen in einer solchen Menge in den Behälter 2 eingeführt wird, daß der Behandlungsflüssigkeitsspiegel 13 sich oberhalb der Schlitze 5 und 6 einstellt.

An der Unterseite der Vorschubebene 10 ist eine Absaugung 14 angeordnet, die über eine Absaugungleitung 15 zu einer in der Zeichnung nicht dargestellten Pumpe führt, beispielsweise einer Strahlpumpe mit Injektordüse. Die Absaugung 14 selbst umfaßt einen sich quer zur Vorschubrichtung über die gesamte Breite der Vorschubebene erstre kenden Absaugschlitz 16, der beispielsweise eine Breite zwischen 0,2 und 0,5 mm aufweisen kann und in einem Abstand zwischen 0,1 und 5 mm unterhalb der Vorschubebene 10 endet.

Im Betrieb der beschriebenen Behandlungsstation 1 ist der Behälter mit einer Behandlungsflüssigkeit 12 gefüllt, die für den jeweiligen Behandlungsschritt benötigt wird. Es kann sich dabei um eine Vielzahl unterschiedlicher Flüssigkeiten handeln, beispielsweise um Reinigungsflüssigkeiten, Vorbehandlungsflüssigkeiten, Aktivierungs- oder Neutralisierungsflüssigkeiten oder Abscheidungsflüssigkeiten, in manchen Fällen auch Öle oder flüssige Lote.

Beim Durchtritt einer Leiterplatte durch den Behälter 2 längs der Vorschubebene 10 überstreicht der Absaugschlitz 16 der Absaugung 14 die gesamte Leiterplattenoberfläche. In diesem Bereich wird Behandlungsflüssigkeit von der Oberseite durch die Bohrungen der Leiterplatte hindurch auf die Unterseite gesaugt und tritt dann in den Absaugschlitz 16 ein, so daß einerseits eine besonders wirksame Durchflutung der Bohrlöcher erreicht wird und andererseits vermieden wird, daß bei der Durchflutung von der Behandlungsflüssigkeit mitgenommene Verunreinigungen in die Behandlungsflüssigkeit 12 des Behälters 2 gelangt. Diese Verunreinigungen gelangen mit der abgesaugten Flüssigkeit in die Absaugleitung 15 und werden nach Durchströmen eines in der Zeichnung nicht dargestellten Filters wieder in den Behälter 2 eingeführt.

Bei der in Fig. 1 dargestellten Behandlungsstation 1 ist eine einzige Absaugung 14 an der Unterseite der Leiterplatte dargestellt. Derartige Absaugungen können sowohl an der Unterseite als auch an der Oberseite der Leiterplatte vorgesehen werden, wobei auch die Zahl der auf jeder Seite angeordneten Absaugungen je nach den Anforderungen größer gewählt werden kann.

Die Wirkung der Absaugung wird dadurch unterstützt, daß der Absaugung gegenüber einer Zufuhr für die Behandlungsflüssigkeit vorgesehen ist, beispielsweise ist die Flüssigkeitseinleitung in den Behälter 2 einer Absaugung gegenüber angeordnet.

Das in Fig. 2 dargestellte Ausführungsbeispiel entspricht weitgehend dem der Fig. 1, gleiche Teile tragen daher dieselbe Bezugszeichen. Zusätzlich zum Ausführungsbeispiel der Fig. 1 ist bei dem Ausführungsbeispiel der Fig. 2 der Absaugung 14 gegenüber ein Ultraschallschwinger 17 in der Behandlungsflüssigkeit angeordnet, so daß die Reinigungswirkung der strömenden Flüssigkeit durch diesen Ultraschallschwinger noch unterstützt wird.

Bei dem Ausführungsbeispiel der Fig. 3 ist eine weitere Behandlungsstation 1 dargestellt, die an sich gleich aufgebaut sein kann wie bei den Ausführungsbeispielen der Fig. 1 und 2. Auch hier sind entsprechenden Teilen dieselben Bezugszeichen zugeordnet. Zusätzlich sind jedoch in Förderrichtung der Leiterplatten stromabwärts der Behandlungsstation 1 auf der Unterseite und auf der Oberseite der Leiterplatten zusätzliche Absaugungen 24 vorgesehen, die ebenfalls über Absaugleitungen 25 mit einer Saugpumpe verbunden sind. Von der Saugpumpe führt eine Rückführleitung in die Behandlungsstation 1 zurück.

Im Unterschied zu der im Innern der Behandlungsstation angeordneten Absaugung befinden sich die Absaugungen 24 in einer gasförmigen Umgebung, normalerweise in Luft, so daß über den Absaugschlitz 26 der Absaugung 24 von den vorbeigeführten Leiterplatten ein Gemisch aus Behandlungsflüssigkeit und Umgebungsgas angesaugt wird. Dabei reißt die angesaugte Luft die an der Leiterplatte haftenden Teilchen der Behandlungsflüssigkeit besonders wirksam von der Leiterplatte weg, so daß auf diese Weise eine sehr vollständige Entferung der Behandlungsflüssigkeit von der Leiterplatte erreicht werden kann. Das Gas-Flüssigkeitsgemisch kann anschließend getrennt werden, so daß die reine Behandlungsflüssigkeit der Behandlungsstation 1 wieder zugeführt werden kann. Dadurch kann die Verschleppung der Behandlungsflüssigkeit so weitgehend reduziert werden, daß eine anschließende Spülung unter Umständen ganz wegfallen kann oder zumindest jedoch der Spülaufwand ganz erheblich herabgesetzt wird.

## Patentansprüche

1. Vorrichtung zur Behandlung von elektrischen Leiterplatten (11) in einem oder mehreren Flüssigkeitsbädern (2) mit einer an mindestens einer Oberfläche der Leiterplatte (11) angeordneten Absaugung (14, 24), wobei die Absaugung (14) im Innern des Flüssigkeitsbades (2) angeordnet ist, der Abstand der Absaugung (14, 24) von der Leiterplatte (11) zwischen 0,1 und 5 mm liegt, die Absaugung (14) einen sich quer zur Leiterplatte (11) erstreckenden Absaugschlitz (16, 26) aufweist, an dem die Leiterplatte (11) vorbeibewegt wird, und der Absaugung (14) gegenüber eine die Flüssigkeit (12) gegen die Leiterplatte (11) richtende Fördereinrichtung angeordnet ist.

2. Vorrichtung nach Anspruch 1, **dadurch gekennzeichnet, dass** die Absaugung (14, 24) eine in das Flüssigkeitsbad (2) führende Rückführung aufweist.

3. Vorrichtung nach Anspruch 1 oder 2, dadurch gekenn-zeichnet, dass auf der der Absaugung (14) abgewandten Seite der Leiterplatte (11) eine Ultraschallreinigungsvorrichtung (17) in der Flüssigkeit (12) angeordnet ist.

4. Vorrichtung nach Anspruch 3, **dadurch gekennzeichnet, dass** die Ultraschallreinigungsvorrichtung (17) der Absaugung (14) unmittelbar gegenüber angeordnet ist.

5. Vorrichtung nach einem der voranstehenden Ansprüche, **dadurch gekennzeichnet, dass** den beiden Seiten der Leiterplatte (11) je mindestens eine Absaugung (14, 24) zugeordnet ist.

6. Vorrichtung nach Anspruch 5, **dadurch gekennzeichnet, dass** die Absaugung (14) eine Fluidstrahlpumpe umfaßt.

7. Vorrichtung nach einem der voranstehenden Ansprüche, **dadurch gekennzeichnet, dass** der Absaugschlitz (16, 26) eine Schlitzbreite zwischen 0,2 und 5 mm hat.

## Claims

1. Apparatus for the treatment of electric circuit boards (11) in one or more liquid baths (2) with a suction means (14, 24) arranged on at least one surface of the circuit board (11), said suction means (14) being located in the interior of the liquid bath (2), the distance between the suction means (14, 24) and the circuit board (11) is between 0.1 and 5 mm, the suction means (14) has a suction slot (16, 26) extending transversely to the circuit board (11) and past which the circuit board (11) is moved, and facing the suction means (14) is provided a feed device directing the liquid (12) against the circuit board (11).

2. Apparatus according to claim 1, **characterized in that** the suction means (14, 24) has a return means leading into the liquid bath (2).

3. Apparatus according to claims 1 or 2, **characterized in that** on the side of the circuit board (11) remote from the suction means (14) is provided in the liquid (12) an ultrasonic cleaning device (17).

4. Apparatus according to claim 3, **characterized in that** the ultrasonic cleaning device (17) is positioned directly facing the suction means (14).

5. Apparatus according to one of the preceding claims, **characterized in that** at least one suction means (14, 24) is associated with each of the two sides of the circuit board (11).

6. Apparatus according to claim 5, **characterized in that** the suction means (14) comprises a fluid jet pump.

7. Apparatus according to one of the preceding claims, **characterized in that** the suction slot (16, 26) has a width between 0.2 and 5 mm.

## Revendications

1. Dispositif de traitement de circuits imprimés électriques (11) doté d'un ou de plusieurs bains de liquides (2) avec une aspiration (14, 24) équipant au moins l'une des surfaces du circuit imprimé (11), l'aspiration (14) étant installée à l'intérieur du bain de liquide (2), la distance de l'aspiration (14, 24) au circuit imprimé (11) étant comprise entre 0,1 et 5 mm, l'aspiration (14) présentant une fente d'aspiration (16, 26) orientée transversalement au circuit imprimé (11), fente devant laquelle le circuit imprimé (11) est déplacé, et avec un dispositif de transport dirigeant le liquide (12) contre le circuit imprimé (11) disposé en face de l'aspiration (14).

2. Dispositif répondant à la revendication 1, **caractérisé par le fait que** l'aspiration (14, 24) présente un retour dirigé vers le bain de liquide (2).

3. Dispositif répondant aux revendications 1 et 2, **caractérisé par le fait que** le côté du circuit imprimé (11) opposé à l'aspiration (14) est équipé d'un dispositif de nettoyage par ultrasons (17) disposé dans le liquide (12).

4. Dispositif répondant à 1a revendication 3, **caractérisé par le fait que** le dispositif de nettoyage à ultrasons (17) est situé directement en face de l'aspiration (14).

5. Dispositif répondant à l'une des revendications précédentes, **caractérisé par le fait qu'**il y a au moins une aspiration (14, 24) disposée de part et d'autre du circuit imprimé (11).

6. Dispositif répondant à la revendication 5, **caractérisé par le fait que** l'aspiration (14) est constituée par une pompe à vide pour fluides.

7. Dispositif répondant à l'une des revendications précédentes, **caractérisé par le fait que** la fente d'aspiration (16, 26) présente une largeur comprise entre 0,2 et 5 mm.
